# EUROPEAN PATENT APPLICATION

(11) **EP 4 761 087 A1**
(43) Date of publication of application: **17.06.2026**
(21) Application number: 24852350.8
(22) Date of filing: 07.08.2024
(51) Int. Cl.: H02M 3/00, H02M 3/335, H05K 7/20, H01F 27/08

(54) **POWER CONVERSION DEVICE**

(30) Priority: 07.08.2023 KR 20230103177; 05.08.2024 KR 20240103729
(71) Applicant: LG INNOTEK CO. LTD, Gangseo-gu Seoul 07796 (KR)
(72) Inventor: YOON, Dong Keun, Seoul 07796 (KR); JUNG, Kwang Soon, Seoul 07796 (KR)
(74) Representative: Plasseraud IP
(86) International application number: PCT/KR2024/011743
(87) International publication number: WO 2025/033997

(57) **Abstract**

A power conversion device according to one embodiment of the present invention comprises: a housing; and an inductor disposed in an inner space of the housing, wherein the inductor includes a core and a coil wound around the core and is disposed such that a surface through which the coil is exposed to the outside faces the air flow direction inside the housing.

## Description

### [Technical Field]

The present invention relates to a power conversion device, and more specifically, to a power conversion device having a high heat dissipation effect of an inductor.

### [Background Art]

To support high-speed charging of hundreds of kW, a rapid charger for charging electric vehicles configures power modules with a capacity of several tens of kW in parallel and outputs high-capacity power. When connected to an electric vehicle, the power module receives AC power from a grid and outputs DC power to charge the battery of the electric vehicle.

A significant amount of heat is generated during power conversion within a power module. A resonant inductor of a resonant circuit constituting the power module is one of the heat-generating components; thus, to ensure product reliability, a technology capable of enhancing the heat dissipation effect of the resonant inductor is required.

### [Detailed Description of the Invention]

### [Technical Subject]

A technical problem to be solved by the present invention is to provide a power conversion device having a high heat dissipation effect of an inductor.

### [Technical Solution]

To solve the technical problem described above, a power conversion device according to an embodiment of the present invention comprises: a housing; and an inductor being disposed in an internal space of the housing, wherein the inductor includes a core and a coil wound around the core, and wherein the inductor is disposed such that a surface where the coil is exposed to the outside faces a direction of air flow inside the housing.

In addition, it may further include a fan disposed in the internal space of the housing to introduce air toward the inside of the housing, and the air flow direction may be formed by the fan.

In addition, the fan may be disposed on one side of the housing, and the housing may include one or more holes through which air is discharged to the outside on a side opposite to the one side where the fan is disposed.

In addition, a center axis of the core of the inductor may be disposed in a direction perpendicular to the air flow direction.

In addition, the power conversion device may include a substrate being disposed in the internal space of the housing, wherein the inductor is mounted on the substrate, and a center axis of the core of the inductor may be disposed in a direction perpendicular to an upper surface of the substrate.

In addition, the inductor may include a plurality of inductors, and the plurality of inductors may be disposed in a direction perpendicular to the air flow direction.

In addition, the core may include a center leg, wherein a center leg gap is formed at a center of the center leg, and a separation direction of the center leg gap may be perpendicular to the air flow direction.

In addition, the core may not be formed in the center leg gap region.

In addition, the power conversion device may include a resonant LLC converter.

In addition, the inductor may be a resonant inductor of the resonant LLC converter.

### [Advantageous Effects]

According to embodiments of the present invention, by arranging the coil surface of the resonant inductor so that it faces the direction of fan flow without using a bobbin, the heat dissipation effect due to fan flow can be increased compared to when a bobbin is used or the coil surface is parallel to the direction of fan flow. In addition, by securing space for air flow between the center leg and the coil, heat conduction between the core and the coil can be prevented, and the heat dissipation effect can be improved.

### [Brief Description of Drawings]

FIG. 1 illustrates a power conversion device according to an embodiment of the present invention.
FIG. 2 is a block diagram of a power conversion device according to an embodiment of the present invention.
FIG. 3 is a circuit diagram of a power conversion device according to an embodiment of the present invention.
FIG. 4 and FIG. 5 are diagrams illustrating an inductor and a fan of a power conversion device according to an embodiment of the present invention.
FIG. 6 to FIG. 8 illustrate an inductor of a power conversion device according to an embodiment of the present invention.
FIG. 9 and FIG. 10 illustrate an inductor of a power conversion device according to a comparative example of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention. In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used.

These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

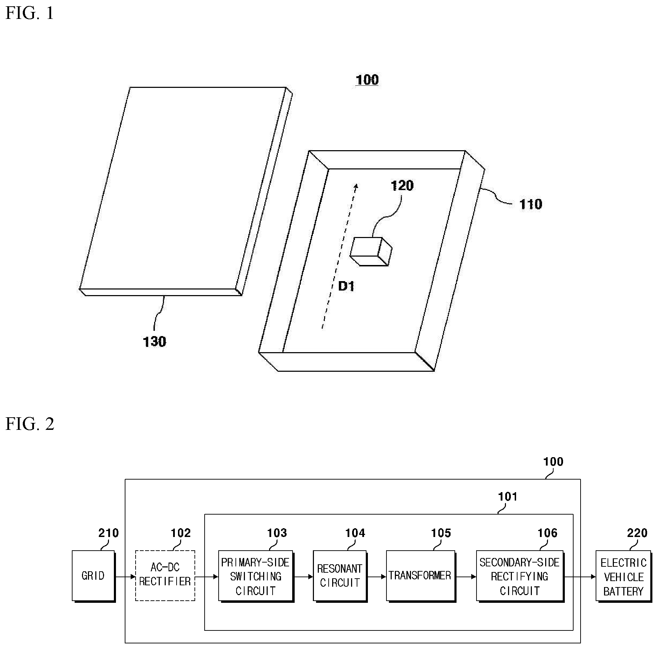

FIG. 1 illustrates a power conversion device according to an embodiment of the present invention. The power conversion device **100** according to an embodiment of the present invention is configured with a housing **110** and an inductor **120,** and may comprise a cover **130,** a fan **140,** a substrate **150,** a resonant LLC converter **101,** an AC-DC rectifier **102,** a primary switching circuit **103,** a resonant circuit **104,** a transformer **105,** and a secondary rectifier circuit **106.**

A power conversion device **100** according to an embodiment of the present invention may be a power conversion device of an electric vehicle charging device. Here, the power conversion device **100** may be a power module of the electric vehicle charging device. The power module may receive AC power from a grid (50/60 Hz) and output the same by converting it into DC power for charging an electric vehicle battery. The power module may include an AC-DC rectifier and an isolated DC-DC converter, and the power conversion device **100** according to an embodiment of the present invention may include an isolated DC-DC converter, and may include a resonant LLC converter among the isolated DC-DC converters.

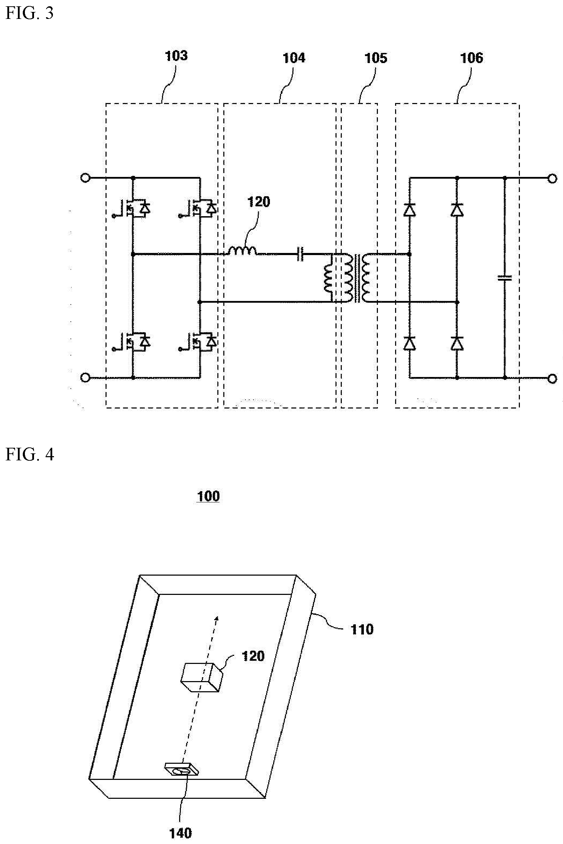

A power conversion device **100** according to an embodiment of the present invention may comprise a primary switching circuit **103,** a resonant circuit **104,** a transformer **105,** a secondary rectifier circuit **106,** and an AC-DC rectifier **102.** As shown in FIG. 2, the power conversion device **100** may include a resonant LLC converter **101** and may further include an AC-DC rectifier **102.** AC power being inputted from a grid **210** may be converted into direct current in the AC-DC rectifier **102,** and may be outputted by being converted into power for charging an electric vehicle battery **220** in the resonant LLC converter **101.** The resonant LLC converter **101** may comprise a primary switching circuit **103,** a resonant circuit **104,** a transformer **105,** and a secondary rectifier circuit **106,** and may be implemented as a circuit as shown in FIG. 3. The primary switching circuit **103** inputs input power to the primary side of the transformer, and the power inputted through the primary switching circuit **103** is outputted to the electric vehicle battery **220** through the transformer **105** and the secondary rectifier circuit **106.** When the primary switching circuit **103** operates, zero switching is possible using the resonant frequency implemented in the resonant circuit **104,** so that switching loss can be reduced and efficiency can be enhanced. The resonant circuit **104** uses a resonant capacitor, a resonant inductor **120,** and a magnetizing inductance being included in a transformer, and is referred to as a resonant LLC converter **101.**

A power conversion device **100** according to an embodiment of the present invention may include a housing **110** and a cover **130** covering the housing **110.**

Components for power conversion are disposed in an internal space of the housing **110,** and the components being disposed in an internal space of the housing **110** include an inductor **120.** Here, the inductor **120** may be a resonant inductor of a resonant circuit **104.** In addition, it may be another inductor or coil being included in the power conversion device **100.**

The inductor **120** includes a core **123** and a coil **124** wound around the core **123.** The core **123** includes a center leg and may include one or more outer legs. The inductor **120** may include various forms of inductors including a coil **124** wound around the core **123.**

The inductor **120** may be disposed so that the surface of the coil **124** exposed to the outside faces the air flow direction **D1** inside the housing **110.** In order to efficiently dissipate heat being generated in the inductor **120,** the inductor **120** does not include a bobbin, so that the coil **124** of the inductor **120** may be exposed to the outside. The surface of the coil **124** of the inductor **120** being exposed to the outside faces the air flow direction **D1** inside the housing **110,** so that a large area of the coil **124** comes into contact with the flowing air, thereby increasing the heat dissipation efficiency of the inductor **120.**

A fan **140** can be disposed in an internal space of the housing **110** to draw in air toward the inside of the housing **110.** The air flow direction **D1** can be formed by the fan **140.** Heat dissipation to the inside of the housing **110** is performed by a fan air cooling method that performs heat dissipation using the fan **140,** and the air flow direction **D1** can be set according to the direction of the fan **140.** A bobbin surrounding the coil **124** may not be used so that the surface of the coil **124** of the inductor **120** exposed to the outside can come into contact with the external air having a low temperature drawn in by the fan **140.** The inductor **120** can be disposed at a position being overlapped with the air flow direction **D1** formed by the fan **140** to increase the effect of heat dissipation. In a position not being overlapped with the air flow direction, air may not be smoothly delivered, or air whose temperature has increased due to other components may be delivered, which may degrade the heat dissipation effect of the inductor **120.** By placing the inductor **120** at a location being overlapped with the air flow direction **D1** formed by the fan **140,** the air can directly contact the inductor **120,** thereby enhancing the heat dissipation effect of the inductor **120.**

The fan **140** is disposed on one side of the housing **110,** and the housing **110** may include one or more holes through which air is discharged to the outside on a side opposite to the one side where the fan **140** is disposed. The holes may be formed in a mesh shape, as vent holes, or the like.

The inductor includes a plurality of inductors **121** and **122,** and the plurality of inductors **120** may be disposed in a direction perpendicular to the air flow direction **D1.** The plurality of inductors **120** may include two or more inductors, and may be disposed side by side in a direction perpendicular to the air flow direction **D1.** When a plurality of inductors **120** are disposed in parallel with the air flow direction **D1,** heat from an inductor that first contacts the air is transferred to the air, thereby increasing the air temperature. As the heated air then flows toward the subsequent inductors, the heat dissipation efficiency for the inductors located behind may be degraded. Accordingly, the plurality of inductors **120** may be disposed side by side in a direction perpendicular to the air flow direction **D1** to enhance the heat dissipation effect.

The fan **140** may include a plurality of fans, and the plurality of fans **140** may be disposed side by side in a direction perpendicular to the air flow direction **D1.** The plurality of fans **140** may be disposed on one side of the housing **110** to introduce external air. The plurality of inductors **121** and **122** may be disposed at positions being overlapped with the air flow direction **D1** being formed by the plurality of fans **140** to enhance the heat dissipation effect.

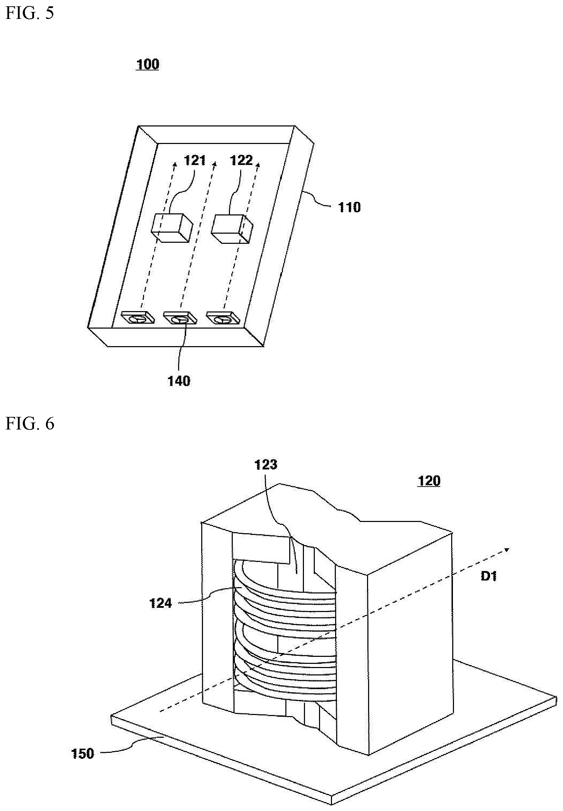

A center axis of the core **123** of the inductor **120** may be disposed in a direction **D2** perpendicular to the air flow direction **D1.** The inductor **120** may be disposed on a substrate **150** being disposed in an internal space of the housing **110.** The inductor **120** is mounted on the substrate **150,** and the center axis of the core **123** of the inductor **120** may be disposed in a direction perpendicular to an upper surface of the substrate **150.** As shown in FIGS. 6 to 8, the center axis of the core **123** may be disposed to face the direction **D2** perpendicular to the air flow direction **D1** such that a surface where the coil **124** not the core **123** being exposed to the outside faces the air flow direction **D1** inside the housing **110.**

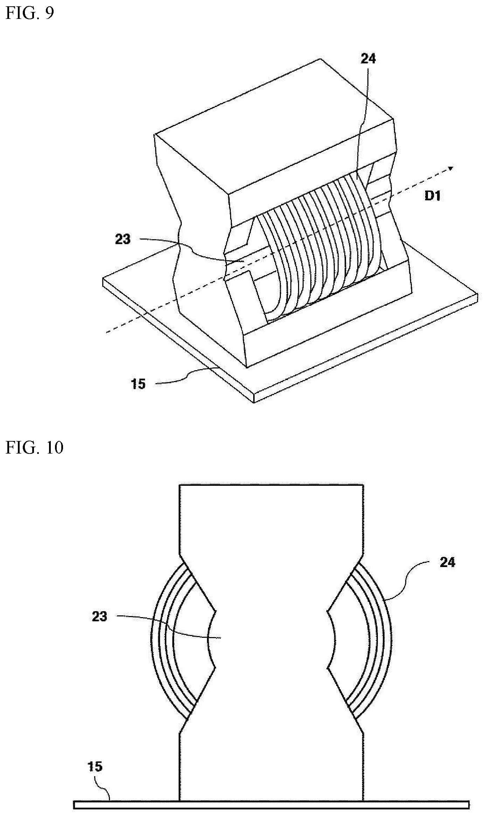

The inductor according to the comparative example of the present invention can be disposed so that the center axis of the core **23** is parallel to the air flow direction **D1,** as shown in FIGS. 9 and 10. In this case, a space is formed between the core **23** and the coil **24** through which air can move, so that the air can flow smoothly. However, the area where the coil **124** and the air meet is concentrated only on the coil **24** located in the air inflow direction, and the subsequent coils **24** only allow the air to pass sideways, and do not have an area that comes into direct contact with the air, so the efficiency of heat dissipation may be degraded. In contrast, when the center axis of the core **123** is disposed to face the direction **D2** perpendicular to the air flow direction **D1,** as shown in FIG. 6, the surface of the coil **124,** not the core **123** of the inductor **120,** exposed to the outside faces the air flow direction **D1** inside the housing **110,** so that the area where the air and the coil **124** come into contact is large, thereby enhancing the heat dissipation effect.

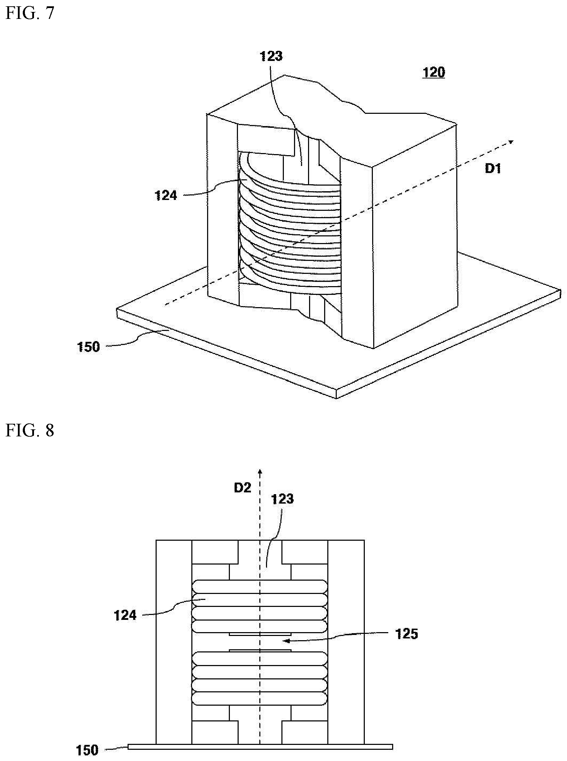

The core **123** of the inductor **120** includes a center leg, and a center leg gap **125** may be formed in the center of the center leg. At this time, the separation direction of the center leg gap **125** may be perpendicular to the air flow direction **D1.** As shown in FIGS. 7 and 8, by forming the center leg gap **125,** even if the center axis of the core **123** is disposed in a direction **D2** perpendicular to the air flow direction **D1,** the air flow may not be obstructed, and the air flow may be made smooth, thereby enhancing the heat dissipation effect. In addition, since the core **123** is not formed in the center leg gap **125** area, the air flow may be made smoother.

The configuration of forming a center leg gap **125** or not forming a core **123** in the center leg gap **125** area may not be an essential configuration for ensuring smooth air flow. Even if a center leg gap **125** is formed, the core **123** may also be formed in the center leg gap **125** area, as shown in FIG. 6. In addition, a configuration in which a coil **124** is wrapped around the core **123** of the inductor **120** can be implemented in various other forms.

In the case of the inductor **120** according to the embodiment of the present invention and the inductor according to the comparative examples of FIGS. 9 and 10, the maximum temperatures of the core and coil were compared. At this time, as a result of the comparison under the conditions in which the specifications of the fan **140,** the specifications of the inductor, the inductor heat generation, and the use of the inductor core and coil were set to the same, it can be confirmed that the inductor **120** according to the embodiment of the present invention and the inductor according to the comparative examples of FIGS. 9 and 10 have core maximum temperatures of 126.8 degrees and 153.7 degrees, respectively, which are about 27 degrees lower for the inductor **120** according to the embodiment of the present invention, and coil maximum temperatures of 130.4 degrees and 151.7 degrees, which are about 21 degrees lower for the inductor **120** according to the embodiment of the present invention. Therefore, it can be confirmed that the heat dissipation effect of the inductor **120** according to the embodiment of the present invention is high.

**[Table 1]**

| | Embodiments of the present invention | Comparative example |
|---|---|---|
| Maximum core temperature (°C) | 126.8 | 153.7 |
| Maximum coil temperature (°C) | 130.4 | 151.7 |

As described above, by arranging the coil **124** of the inductor **120** so that the surface exposed to the outside faces the direction of flow of the fan **140** without using a bobbin, the heat dissipation effect by fan flow can be enhanced compared to when a bobbin is used or the coil surface is parallel to the direction of flow of the fan. In addition, by securing space for air flow between the center leg and the coil, heat conduction between the core and the coil can be prevented, and the heat dissipation effect can be enhanced.

Those skilled in the art will appreciate that the present invention can be implemented in modified forms without departing from the essential characteristics of the above-described description. Therefore, the disclosed methods should be considered illustrative rather than restrictive. The scope of the present invention is set forth in the claims, not the foregoing description, and all differences within the scope equivalent thereto should be construed as being encompassed by the present invention.

## Claims

1. A power conversion device comprising:
a housing; and
an inductor disposed in an internal space of the housing,
wherein the inductor comprises a core and a coil wound around the core, and
wherein the inductor is disposed such that a surface where the coil is exposed to outside faces a direction of air flow inside the housing.

2. The power conversion device according to claim 1, comprising:
a fan disposed in the internal space of the housing to introduce air toward the inside of the housing,
wherein the air flow direction is formed by the fan.

3. The power conversion device according to claim 1,
wherein the fan is disposed on one side of the housing, and
wherein the housing comprises one or more holes through which air is discharged to outside on a side opposite to the one side where the fan is disposed.

4. The power conversion device according to claim 1,
wherein a center axis of the core of the inductor is disposed in a direction perpendicular to the air flow direction.

5. The power conversion device according to claim 1, comprising:
a substrate disposed in the internal space of the housing,
wherein the inductor is mounted on the substrate,
wherein a center axis of the core of the inductor is disposed in a direction perpendicular to an upper surface of the substrate.

6. The power conversion device according to claim 1,
wherein the inductor comprises a plurality of inductors, and
wherein the plurality of inductors is disposed in a direction perpendicular to the air flow direction.

7. The power conversion device according to claim 1,
wherein the core comprises a center leg,
wherein a center leg gap is formed at a center of the center leg, and
wherein a separation direction of the center leg gap is perpendicular to the air flow direction.

8. The power conversion device according to claim 7,
wherein the core is not formed in a region of the center leg gap.

9. The power conversion device according to claim 1,
wherein the power conversion device comprises a resonant LLC converter.

10. The power conversion device according to claim 9,
wherein the inductor is a resonant inductor of the resonant LLC converter.
